Europäisches Patentamt

European Patent Office

Office européen des brevets

(19)

(11) Veröffentlichungsnummer: **0 356 670 B1**

# (12) EUROPÄISCHE PATENTSCHRIFT

(45) Veröffentlichungstag der Patentschrift: **06.10.93**

(51) Int. Cl.⁵: **G01R 15/07**

(21) Anmeldenummer: **89112741.7**

(22) Anmeldetag: **12.07.89**

(54) **Faseroptischer Stromsensor.**

(30) Priorität: **31.08.88 CH 3246/88**

(43) Veröffentlichungstag der Anmeldung:
**07.03.90 Patentblatt 90/10**

(45) Bekanntmachung des Hinweises auf die
Patenterteilung:
**06.10.93 Patentblatt 93/40**

(84) Benannte Vertragsstaaten:
**CH DE LI SE**

(56) Entgegenhaltungen:
**EP-A- 0 108 671**
**FR-A- 2 475 230**

(73) Patentinhaber: **ASEA BROWN BOVERI AG**
**Haselstrasse**
**CH-5401 Baden(CH)**

(72) Erfinder: **Bertholds, Axel, Dr.**
**Saars 85**
**CH-2000 Neuchâtel(CH)**
Erfinder: **Maystre, François**
**Saars 85**
**CH-2000 Neuchâtel(CH)**

# Beschreibung

TECHNISCHES GEBIET, STAND DER TECHNIK

Die Erfindung betrifft einen faseroptischen Stromsensor mit einem Singlemode-Lichtwellenleiter, welcher um einen elektrischen Leiter gewickelt ist, mit Mitteln zum Einkoppeln von kohärentem Licht in den Singlemode-Lichtwellenleiter, und mit Mitteln zum Detektieren der aus dem Singlemode-Lichtwellenleiter ausgekoppelten Intensität unter Ausnützung des magnetooptischen Faradayeffekts.

Ein solcher Stromsensor ist z.B. aus der Druckschrift EP-A1-0 108 671 bekannt.

Es ist bekannt, dass Glasfasern aufgrund des magnetooptischen Faradayeffekts als Stromsensoren verwendet werden können. Dazu wird die Glasfaser um einen elektrischen Leiter gewickelt und die durch den Strom induzierte Drehung der Polarisation des in der Glasfaser geführten Lichts gemessen.

Ein solcher faseroptischer Stromsensor ist z.B. aus "Optical fibre current measurement" von A. J. Rogers, Proc. of the Soc. phot-opt. Intr. Engineers, SPIE 374, 1983, bekannt. Eine Glasfaser, welche mehrere Male um einen elektrischen Leiter gewickelt ist, dient als Sensor. An einem Ende der Glasfaser wird Licht eines He-Ne-Lasers eingekoppelt. Am anderen Ende der Glasfaser ist ein Wollaston-Prisma angeordnet, welches das Licht polarisationsmässig aufspaltet und zwei Photodetektoren zuführt.

Die Probleme dieser Anordnung liegen einerseits bei dem wegen der Doppelbrechung nötigen grossen Krümmungsradius der Glasfaser und andererseits bei der vibrationsempfindlichen Detektion mit dem Wollaston-Prisma. Um den Einfluss der Doppelbrechung zu verringern, ist in der eingangs genannten Druckschrift EP-A-0 108 671 bei einer vergleichbaren Stromsensor-Anordnung bereits vorgeschlagen worden, die faseroptischen Zuleitungen zum eigentlichen Sensor gegensinnig zu tordieren.

Aus der Druckschrift "Messverfahren zur Strommessung in Hochspannungsanlagen (Faraday-Effekt in Lichtwellenleitern)", W.D. Bergmann und H. Winterhoff, Technisches Messen 50, Jg. 1983, Heft 2, ist weiterhin ein Stromsensor mit Kompensation bekannt. Das Licht einer Laserdiode wird in einen Lichtwellenleiter mit Messspule und Kompensationsspule eingekoppelt. Zur Verstärkung des Faradayeffekts wird der Lichtwellenleiter an einem Ende verspiegelt, so dass das Licht die Messspule zweimal durchläuft.

Es zeigt sich, dass bei dieser Anordnung Interferenzen auftauchen, die das Messsignal zerstören können. Um dies zu vermeiden, müssen die Enden der Sensorfaser mit einem Schrägschliff versehen werden.

Das Problem bei den bekannten Sensoren liegt darin, dass einerseits für eine hohe Empfindlichkeit eine grosse Zahl von Wicklungen und damit auch ein langer Lichtwellenleiter nötig sind, dass andererseits aber ein kurzer Lichtwellenleiter wünschenswert ist, um den Einfluss von Unvollkommenheiten der Glasfaser möglichst gering zu halten.

DARSTELLUNG DER ERFINDUNG

Aufgabe der Erfindung ist es , einen faseroptischen Stromsensor der eingangs genannten Art zu schaffen, welcher eine grosse Empfindlichkeit bei geringen geometrischen Abmessungen aufweist.

Die Aufgabe wird bei einem Stromsensor der eingangs genannten Art dadurch gelöst, dass

(a) der Singlemode-Lichtwellenleiter mittels jeweils eines an seinen beiden Enden vorhandenen Spiegels als faseroptischer Fabry-Perot-Resonator ausgebildet ist;

(b) der Fabry-Perot-Resonator eine Länge hat, die einem halben oder einem ganzzahligen Vielfachen einer halben Schwebungslänge des eingekoppelten Lichts entspricht;

(c) der Fabry-Perot-Resonator die Form einer Helix hat, die den elektrischen Leiter genau N mal umrundet, wobei N eine positive ganze Zahl ist; und

(d) die Mittel zum Einkoppeln von kohärentem Licht einen auf eine Resonanzfrequenz des faseroptischen Fabry-Perot-Resonators stabilisierten Laser umfassen.

Der Kern der Erfindung liegt darin, dass

1. der faseroptische Fabry-Perot-Resonator (im nachfolgenden kurz nur noch als "Fabry-Perot" bezeichnet) den Faradayeffekt verstärkt, ohne einen langen Lichtwellenleiter zu benötigen,

2. durch die geometrische Torsion der Helix der störende Effekt der biegeinduzierten Doppelbrechung unterdrückt wird, und

3. die Faraday-Drehung der Polarisation weitgehend unabhängig von der Stromverteilung im elektrischen Leiter ist, da das faseroptische Fabry-Perot den elektrischen Leiter genau N-mal umrundet.

Vorzugsweise ist das faseroptische Fabry-Perot eine Singlemode-Quarzglasfaser und hat eine Finesse F kleiner als 100, wobei die Finesse in bekannter Weise als Verhältnis des Abstandes benachbarter Durchlassmaxima des Fabry-Perot-Resonators zu deren Halbwertsbreite definiert ist.

Zum Messen des Faradayeffekts eignen sich sowohl Direkt-Detektion als auch Heterodyn-Detektion. Das faseroptische Fabry-Perot kann dabei entweder in Transmission oder in Reflexion betrieben werden.

Weitere vorteilhafte Ausführungsformen ergeben sich aus den abhängigen Patentansprüchen.

## Kurze Beschreibung der Zeichnung

Nachfolgend soll die Erfindung anhand von Ausführungsbeispielen und im Zusammenhang mit der Zeichnung näher erläutert werden. Es zeigen:

Fig. 1 ein erfindungsgemässes faseroptisches Fabry-Perot;

Fig. 2 einen faseroptischen Stromsensor, bei welchem das faseroptische Fabry-Perot in Transmission betrieben und der Faradayeffekt in Direkt-Detektion gemessen wird;

Fig. 3 einen faseroptischen Stromsensor, bei welchem das faseroptische Fabry-Perot in Transmission betrieben und der Faradayeffekt mit Heterodyn-Detektion gemessen wird;

Fig. 4 einen faseroptischen Stromsensor, bei welchem das faseroptische Fabry-Perot in Transmission betrieben und der Faradayeffekt mit einem Sagnac-Interferometer gemessen wird;

Fig. 5 einen faseroptischen Stromsensor, bei welchem das faseroptische Fabry-Perot in Reflexion betrieben und der Faradayeffekt in Direkt-Detektion gemessen wird; und

Fig. 6a,b Ausführungsformen eines Viertelwellenverzögerers.

## Wege zur Ausführung der Erfindung

Zum besseren Verständnis der Erfindung soll zuerst kurz deren physikalischer Hintergrund beleuchtet werden.

Zur Beschreibung des Faradayeffekts in Singlemode-Lichtwellenleitern eignet sich bekanntlich am besten die Basis der zirkularen Polarisationszustände. In dieser Basis erfahren die Eingenzustände (rechts- bzw. linkszirkulare Polarisation) bei einer Biegung des Lichtwellenleiters eine unterschiedliche Phasendrehung pro Weglänge (Doppelbrechung, engl. birefringence). Die Wegstrecke, nach welcher die beiden Polarisationszustände eine Phasendifferenz von 360° aufweisen, wird Schwebungslänge (engl. beat length) genannt.

Für die Beschreibung der Lichtausbreitung in einem beliebig gekrümmten Lichtwellenleiter wird auf C. H. Tang, IEEE Trans. MIcrowave Theory Tech., MTT-18, 69 (1970) und auf J. N. Ross, Opt. and Quant. Electron. 16, 455 (1984) verwiesen.

Das erfindungsgemässe faseroptische Fabry-Perot in der Form einer Helix muss die folgenden Bedingungen erfüllen.

Erstens muss die Helix den den zu messenden Strom i aufweisenden elektrischen Leiter genau N Mal umrunden, damit die Messung unabhängig von der Stromverteilung ist. Dies ergibt für die Länge s der Helix folgende Bedingung:

$$s = 2\pi R\, N\, /\, \cos\theta \qquad (I)$$

$R$ = Radius der Helix
$\theta$ = Neigungswinkel der Helix
$N$ = vorgebbare, positive, ganze Zahl

Zweitens muss die Länge s der Helix gleich dem halben oder einem ganzzahligen Vielfachen der halben Schwebungslänge des entsprechend geformten Singlemode-Lichtwellenleiters sein. Dies entspricht der Bedingung:

$$\Gamma s = m\pi \qquad (II)$$

$\Gamma$ = $(\tau^2 + (\beta/2)^2)^{1/2}$
$\tau$ = geometrische Torsion der Helix
$\beta$ = biegeinduzierte Doppelbrechung
$m$ = vorgebbare, positive, ganze Zahl

Durch Verknüpfen der beiden Bedingungen ergibt sich eine Beziehung, aus welcher sich der Neigungswinkel $\theta$ der Helix ermitteln lässt:

$$4\,\sin^2\theta\ +\ ((\pi n^3/2)(p_{11}\text{-}p_{12})(1+v)(r^2/\lambda R)^2)^2\cos^6\theta\ -\ 1\ =\ \emptyset \qquad (III)$$

$n$ = Brechungsindex
$p_{11}\text{-}p_{12}$ = Differenz der photoelastischen Koeffizienten von Kern und Mantel
$v$ = Poissonverhältnis
$r$ = Radius des Lichtwellenleiters
$\lambda$ = Wellenlänge des Lichts

Typischer Weise liegt der Neigungswinkel $\theta$ bei etwa 30°. Dies ergibt sich z.B. bei einer Quarzglasfaser mit Brechungsindex n = 1.45, ($p_{11}\text{-}p_{12}$ = Ø.14, v = Ø.16, äusserem Radius r = 4Ø μm, und bei einer Wellenlänge λ = 78Ø nm und einen Radius der Helix R > 1Ø mm.

Im folgenden werden nun bevorzugte Ausführungsformen der Erfindung beschrieben.

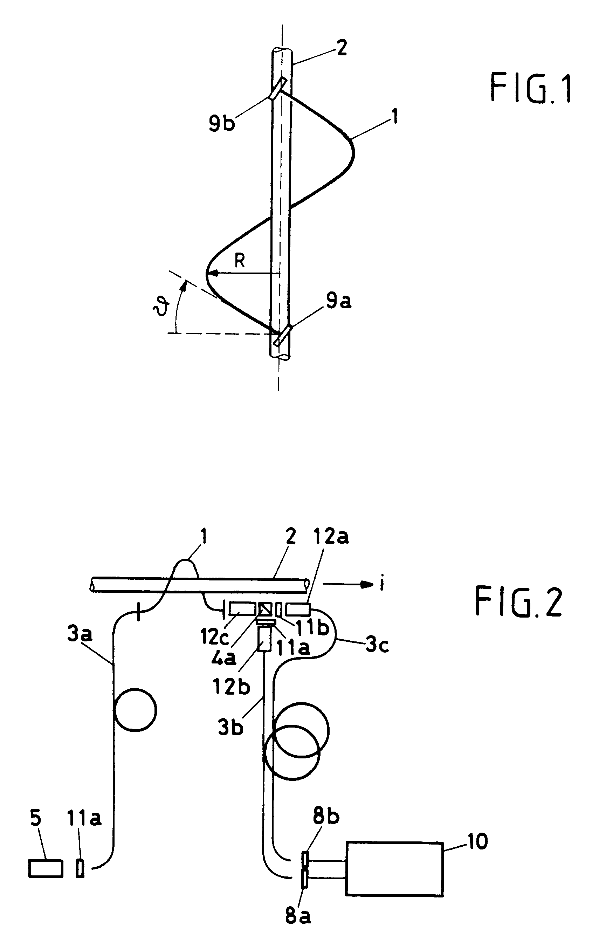

Fig. 1 zeigt ein erfindungsgemässes faseroptisches Fabry-Perot 1. Es hat die Form einer Helix mit einem Radius R, einer Länge s und einem Neigungswinkel $\theta$. Die Helix umrundet den elektrischen Leiter 2, welcher im wesentlichen auf der Achse der Helix liegt, gemäss einer bevorzugten Ausführungsform genau einmal.

Das faseroptische Fabry-Perot 1 wird durch einen Singlemode-Lichtwellenleiter gebildet, der an seinen Enden mit dielektrischen oder metallischen Spiegeln 9a, 9b versehen ist. In Transmission können die Spiegel 9a, 9b identisch sein. In Reflexion dagegen sollte der Spiegel, bei dem das Licht eingekoppelt wird, eine geringere Reflexivität besitzen. Durch die Finesse des faseroptisches Fabry-Perot 1 wird der Verstärkungsfaktor für den Faradayeffekt bestimmt. Die Linienbreite des eingekoppelten Lichts bestimmt jedoch den maximal erreichbaren Verstärkungsfaktor.

Gemäss einer bevorzugten Ausführungsform ist der Singlemode-Lichtwellenleiter eine schwach doppelbrechende Quarzglasfaser. Ferner hat die Helix einen Radius R von mehr als 1Ø mm und einen Neigungswinkel $\theta$ von etwa 30°. Die Finesse F des faseroptischen Fabry-Perot schliesslich ist nicht grösser als 1ØØ.

Bei gewissen Anwendungen kann es vorteilhaft sein, wenn der Radius der Helix möglichst gross ist. In solchen Fällen wird man die Länge s des faseroptischen Fabry-Perot auf ein ganzzahliges Vielfaches der Schwebungslänge festsetzen. Andrerseits kann die Helix den elektrischen Leiter auch genau zweimal (allgemein genau N Mal) umrunden. Es ist allein darauf zu achten, dass die Bedingung (III) erfüllt ist.

Fig. 2 zeigt einen faseroptischen Stromsensor, bei welchem das faseroptische Fabry-Perot in Transmission betrieben und der Faradayeffekt in Direkt-Detektion gemessen wird.

Das Licht eines Lasers 5 wird mit einem Polarisator 11a linear polarisiert und in eine erste Uebertragungsleitung 3a eingekoppelt. Als optische Uebertragungsleitung 3a wird eine stark doppelbrechende Glasfaser verwendet, damit die Polarisation des Lichts bei der Uebertragung erhalten bleibt. Der Polarisator 11a ist bezüglich der zueinander orthogonalen Doppelbrechungsachsen der Glasfaser so ausgerichtet, dass die Polarisationsrichtung des eingekoppelten Lichts einen Winkel von 45° mit den Doppelbrechungsachsen einschliesst.

Das übertragene Licht wird in ein erfindungsgemässes faseroptisches Fabry-Perot 1 eingekoppelt, welches einen elektrischen Leiter 2 und damit einen Strom i umrundet. Das vom faseroptischen Fabry-Perot transmittierte Licht wird mit einer Linse 12c ausgekoppelt und mit einem Strahlteiler 4a in zwei Teilstrahlen zerlegt, welche mit zwei Polarisatoren 11a, 11b bezüglich der +45° resp. -45° Komponenten analysiert werden.

Die analysierten Teilstrahlen werden jeweils mit einer Linse 12a resp. 12b in eine zweite resp. dritte Uebertragungsleitung 3b resp 3c eingekoppelt und zu Photodetektoren 8a resp. 8b geführt. Im Gegensatz zur ersten Uebertragungsleitung 3a brauchen die anderen beiden keine stark doppelbrechende Singlemode-Lichtwellenleiter zu sein; es genügen Multimode-Glasfasern. Aus den von den Photodetekoren 8a, 8b detektierten Intensitäten $I_1$, $I_2$ wird in einer nachgeschalteten Auswerteelektronik 1Ø der Strom i ermittelt.

Bei der Anordnung gemäss Fig. 2 messen die Photodetektoren 8a, 8b eine Lichtintensität $I_1$ resp. $I_2$, deren Abhängigkeit vom Drehwinkel $\phi$ des Faradayeffekts von der Form

$$I_1 = I_{\emptyset 1}(1 + \sin \phi)$$
$$I_2 = I_{\emptyset 2}(1 - \sin \phi)$$

ist. Für kleine Drehwinkel $\phi$ ist der Quotient $(I_1 - I_2)/(I_1 + I_2)$ proportional zu $\phi$ und damit proportional zum Strom i.

Für den erfindungsgemässen faseroptischen Stromsensor ist es wichtig, dass der Laser 5 auf eine Resonanzfrequenz des faseroptischen Fabry-Perot stabilisiert ist.

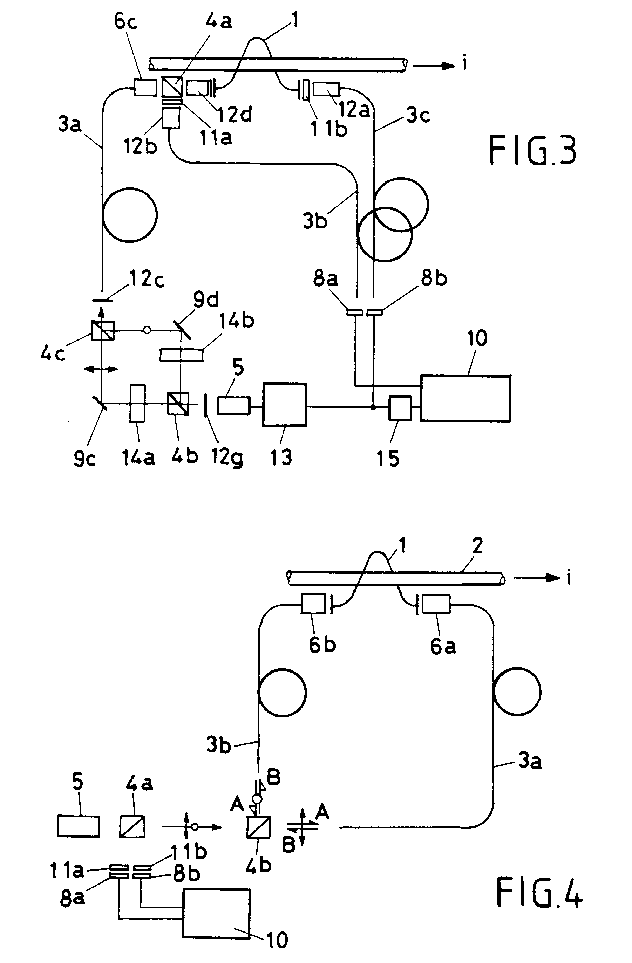

Fig. 3 zeigt eine Ausführungsfomr mit Heterodyn-Detektion. In Fig. 3 sind Teile, die bereits in Fig. 1 beschrieben sind, mit entsprechenden Bezugszeichen versehen.

Ein temperaturstabilisierter Singlemode-Laser 5 wird mittels eines Frequenzreglers 13 z.B. mit 1Ø kHz frequenzmoduliert. Die Modulation soll einem Bruchteil der Bandbreite des faseroptischen Fabry-Perot 1 entsprechen. Das Laserlicht wird in einer Linse 12g kollimiert und dann in einem polarisierenden Strahlteiler 4b in zwei linear polarisierte Teilstrahlen aufgeteilt. Jeder der beiden Teilstrahlen wird in einem akustooptischen Modulator 14a resp. 14b frequenzmoduliert. Die beiden Modulationsfrequenzen betragen beispielsweise 4Ø.Ø MHz resp 4Ø.1 MHz und unterscheiden sich damit gemäss einer bevorzugten Ausführungsform um 1ØØ kHz.

Zwei Spiegel 9c, 9d und ein zweiter polarisierender Strahlteiler 4c führen die beiden modulierten Teilstrahlen wieder zusammen. Danach wird der modulierte Strahl mit einer Linse 12c in eine polarisationserhaltende, erste Uebertragungsleitung 3a eingekoppelt.

Am Ende der Uebertragungsleitung 3a sind ein Viertelwellenverzögerer 6c (engl. quarter wave retarder) und ein Strahlteiler 4a angeordnet. Ein erster Teilstrahl des Strahlteilers 4a wird als Referenz mit einem Polarisator 11a analysiert, mit einer Linse 12b in eine zweite Uebertragungsleitung 3b eingekoppelt und dann vom Photodetektor 8a gemessen. Ein zweiter Teilstrahl des Strahlteilers 4a wird mit einer Linse 12d in das faseroptische Fabry-Perot 1, welches in Transmission betrieben wird, eingekoppelt, dahinter von einem Polarisator 11b analysiert, mit einer Linse 12a in eine dritte Uebertragungsleitung 3c eingekoppelt und dann vom Photodetektor 8b als Messignal detektiert.

Das Messignal wird einerseits auf den Frequenzregler 13 zurückgeführt, welcher daraus ein Fehlersignal zum Steuern der Modulation des Lasers 5 extrahiert, und andrerseits in einem Bandpassfilter 15 gefiltert, dessen Durchlassfrequenz im vorliegenden Beispiel bei 100 kHz liegt. In einer Auswerteelektronik 10 (Phasenmeter) wird die Phasendifferenz zwischen dem so gefilterten Messignal und dem Referenzsignal ermittelt und daraus der Strom i bestimmt.

Die beschriebene Messanordnung zeichnet sich durch zwei Prinzipien aus, nämlich durch eine Feedback-Schleife, welche die Laserfrequenz auf eine Resonanzfrequenz des faseroptischen Fabry-Perot einregelt, und durch eine genaue Messung der Phasendifferenz zwischen den beiden Polarisationszuständen. Wegen der sich stark ändernden Amplitude in der Umgebung der Resonanz ist es wichtig, die Phasendifferenz unabhängig von der Amplitude zu messen.

Die im zweiten Ausführungsbeispiel verwendete Heterodyn-Polarisations-Interferometrie ist als solche bekannt und in der Druckschrift "High sensitivity Fabry-Perot optical fiber sensor for the measurement of mechanical force", F. Maystre et al., Optical Fiber Sensors, 1988 Tech. Digest Series, 2 (Opt. Soc. of America) pp. 424 - 432, ausführlich beschrieben.

Fig. 4 zeigt einen faseroptischen Stromsensor, bei welchem das faseroptishe Fabry-Perot in Transmission betrieben und der Faradayeffekt mit einem Sagnac-Interferometer gemessen wird. Wiederum sind Teile, die bereits in den vorhergehenden Figuren beschrieben worden sind mit entsprechenden Bezugzeichen versehen.

Ein Laser 5 liefert zwei zueinander orthogonal polarisierte Teilstrahlen A, B. Diese werden im einem polarisierenden Strahlteiler 4b getrennt. Der erste Teilstrahl A läuft über eine erste Uebertragungsleitung 3a, einen ersten Viertelwellenverzögerer 6a, das faseroptische Fabry-Perot 1, wobei er eine Phasenschiebung erleidet, einen zweiten Viertelwellenverzögerer 6b und eine zweite Uebertragungsleitung 6b zum polarisierenden Strahlteiler 4b zurück. Der Teilstrahl B durchläuft die selbe Strekke, jedoch in entgegengesetzter Richtung.

Ein Strahlteiler 4a koppelt die aus dem polarisierenden Strahlteiler 4b zurückkehrenden, phasenverschobenen Teilstrahlen A, B aus, sodass sie auf bereits beschriebene Weise analysiert werden können.

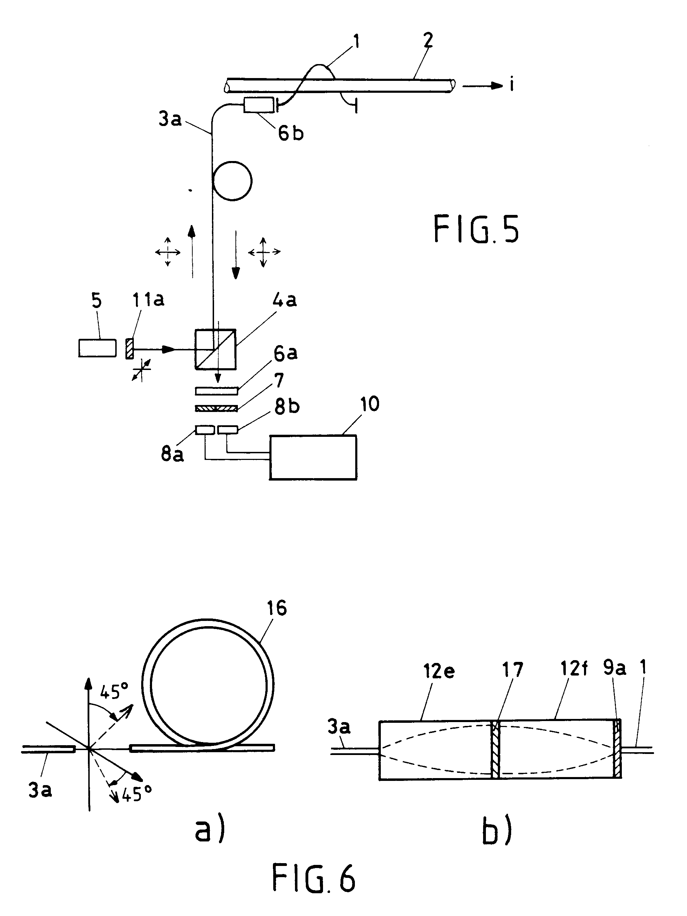

Fig. 5 zeigt einen faseroptischen Stromsensor, bei welchem das faseroptische Fabry-Perot in Reflexion betrieben und der Faradayeffekt in Direkt-Detektion gemessen wird.

An einem Ende des faseroptischen Fabry-Perot 1 ist ein Viertelwellenverzögerer 6b (wandelt linear polarisiertes Licht in zirkular polarisiertes um und umgekehrt) angeordnet, welcher die Verbindung zwischen faseroptischem Fabry-Perot 1 und einer optischen Uebertragungsleitung 3a schafft.

Zum Ein- und Auskoppeln von kohärentem Licht in resp. aus der Uebertragungsleitung 3a ist ein Strahlteiler 4a vorgesehen. Das einzukoppelnde Licht liefert ein Laser 5 (z.B. eine Laserdiode) mit nachgeschaltetem Polarisator 11a. Das ausgekoppelte Licht durchläuft eine Viertelwellenverzögerer 6a und einen Kreuzpolarisator 7 und fällt dann mit einer Intensität $I_1$ resp. $I_2$ auf zwei Photodetektoren 8a resp. 8b. Eine Auswerteelektronik 10 ermittelt aus den beiden gemessenen Intensitäten $I_1$ und $I_2$ den im elektrischen Leiter 2 fliessenden Strom i.

Wegen des Viertelwelllenverzögerers 6b ist die Polarisationsrichtung des zurücklaufenden Lichts um 90° gegenüber dem hinlaufenden Licht gedreht. (Siehe dazu die Pfeildiagramme in Fig. 1.) Damit ist gewährleistet, dass beide Polarisationsmoden des faseroptischen Fabry-Perot 1 den selben Weg durchlaufen. Störeffekte werden damit automatisch eliminiert.

Der Kreuzpolarisator 7 ist bezüglich der Doppelbrechungsachsen der Uebertragungsleitung 3a so orientiert, dass er zwei Strahlen mit Polarisationsrichtung +/-45° liefert.

Im folgenden werden noch einige Gesichtspunkte erwähnt, die allen Ausführungsformen der Erfindung gemeinsam sind.

Aeussere Störungen, welche die Länge der Glasfaser beeinflussen, wirken sich gleichermassen auf beide Polarisationszustände aus und verändern den Wert der strominduzierten zirkularen Doppelbrechung nicht. Daher ist der faseroptische Stromsensor unempfindlich gegen Temperaturschwankungen.

Die Dynamik des Stromsensors ist begrenzt durch die Resonanzbreite des faseroptischen Fabry-Perot (ca. +/-45°). Die gemessene Phasendifferenz wird damit etwa +/-1.2 / F (F = Finesse des Fabry-Perot). Die Empfindlichkeit am Rand des Messbereichs ist aber immer noch etwa 85% des Maximalwertes (in der Mitte der Resonanz).

Die relative Empfindlichkeit ist gegeben durch die Genauigkeit der Phasenmessung, d.h. durch das Detektionsverfahren und das Verhältnis von Signal zu Rauschen im Vergleich zur Dynamik.

Die Finesse des Fabry-Perot wird dem gewünschten Messbereich angepast. Wenn das faseroptische Fabry-Perot z.B. aus einer Quarzglasfaser besteht und der Messbereich +/-2000 A betragen soll, dann sollte die Finesse nicht grösser als 100 sein, was einem Verstärkungsfaktor von etwa 66 entspricht.

Fig. 6a,b zeigt zwei bevorzugte Ausführungsformen der Viertelwellenverzögerer 6a, 6b, 6c. Gemäss Fig. 6a wird eine 90° Verzögerung durch eine zu einer Schleife gebogene, schwach doppelbrechende Singlemode Glasfaser 16 erzeugt. Die Doppelbrechungsachsen (gestrichelte Pfeile) der Uebertragungsleitung 3a sind um 45° gegenüber der langsamen resp. der schnellen Achse der gekrümmten Glasfaser 16 gedreht.

Fig. 6b zeigt eine Ausführungsform mit GRIN-rod Linsen 12e, 12f (GRIN = GRaded INdex) und einer dazwichen angeordneten λ/4-Platte 17. Eine erste GRIN-rod Linse 12e wird an der Uebertragungsleitung 3a, und eine zweite GRIN-rod Linse 12f wird an einem Spiegel 9a des faseroptischen Fabry-Perot 1 angebracht.

Es versteht sich, dass die Erfindung nicht auf die beschriebenen Ausführungsformen beschränkt ist. So kann die Heterodyn-Detektion z.B. auch in Verbindung mit einem in Reflexion betriebenen faseroptischen Fabry-Perot vorteilhaft eingesetzt werden. Selbstverständlich können auch andere Polarisations-Interferometer zum Messen der Faradayrotation im erfindungsgemässen faseroptischen Fabry-Perot verwendet werden.

Abschliessend kann gesagt werden, dass die Erfindung einen faseroptischen Stromsensor schafft, welcher bei kurzer Faserlänge eine hohe Empfindlichkeit besitzt und dadurch Störungen, welche durch Inhomogenitäten der Lichtwellenleiter hervorgerufen werden, auf ein Minimum reduziert.

## Patentansprüche

1. Faseroptischer Stromsensor mit einem Singlemode-Lichtwellenleiter, welcher um einen elektrischen Leiter (2) gewickelt ist, mit Mitteln zum Einkoppeln von kohärentem Licht in den Singlemode-Lichtwellenleiter, und mit Mitteln zum Detektieren der aus dem Singlemode-Lichtwellenleiter ausgekoppelten Intensität unter Ausnützung des magnetooptischen Faradayeffekts, dadurch gekennzeichnet, dass

(a) der Singlemode-Lichtwellenleiter mittels jeweils eines an seinen beiden Enden vorhandenen Spiegels (9a, 9b) als faseroptischer Fabry-Perot-Resonator (1) ausgebildet ist;

(b) der Fabry-Perot-Resonator (1) eine Länge hat, die einem halben oder einem ganzzahligen Vielfachen einer halben Schwebungslänge des eingekoppelten Lichts entspricht;

(c) der Fabry-Perot-Resonator (1) die Form einer Helix hat, die den elektrischen Leiter (2) genau N mal umrundet, wobei N eine positive ganze Zahl ist; und

(d) die Mittel zum Einkoppeln von kohärentem Licht einen auf eine Resonanzfrequenz des faseroptischen Fabry-Perot-Resonators (1) stabilisierten Laser (5) umfassen.

2. Faseroptischer Stromsensor nach Anspruch 1, dadurch gekennzeichnet, dass die Helix einen Neigungswinkel (θ) von etwa 30° hat.

3. Faseroptischer Stromsensor nach Anspruch 2, dadurch gekennzeichnet, dass die Helix den elektrischen Leiter (2) genau einmal umrundet.

4. Faseroptischer Stromsensor nach Anspruch 3, dadurch gekennzeichnet, dass der faseroptische Fabry-Perot-Resonator (1) eine Quarzglasfaser ist und eine Finesse (F) kleiner als 100 hat, wobei als Finesse das Verhältnis des Abstandes benachbarter Durchlassmaxima des Fabry-Perot-Resonators zu deren Halbwertsbreite definiert ist.

5. Faseroptischer Stromsensor nach Anspruch 4, dadurch gekennzeichnet, dass die Quarzglasfaser eine schwach doppelbrechende Glasfaser ist und dass die Helix einen Radius (R) hat, welcher grösser als 10 mm ist.

6. Faseroptischer Stromsensor nach Anspruch 1, dadurch gekennzeichnet, dass die Mittel zum Einkoppeln von kohärentem Licht und Detektieren des magnetooptischen Faradayeffekts mindestens eine polarisations-erhaltende Uebertragungsleitung (3a) aus einer stark doppelbrechenden Glasfaser umfassen, welche an einem Ende des faseroptischen Fabry-Perot-Resonators (1) angeschlossen ist.

7. Faseroptischer Stromsensor nach Anspruch 6, dadurch gekennzeichnet, dass der faseroptische Fabry-Perot-Resonator (1) in Transmission betrieben und der magnetooptische Faradayeffekt mit Direkt-Detektion gemessen wird, wobei die Mittel zum Einkoppeln von kohärentem Licht und Detektieren des magnetooptischen Faradayeffekts drei Uebertragungsleitungen (3a, 3b, 3c) aufweisen, von denen mindestens eine polarisations-erhaltend ist, sowie einen Strahlteiler (4a) und zwei Polarisatoren (11a, 11b) zum Analysieren des transmittierten Lichts.

8. Faseroptischer Stromsensor nach Anspruch 6, dadurch gekennzeichnet, dass der faseroptische Fabry-Perot-Resonator (1) in Transmission betrieben und der magnetooptische Faradayeffekt in Heterodyn-Detektion gemessen wird, wobei die Mittel zum Einkoppeln von kohärentem Licht und Detektieren des magnetooptischen Faradayeffekts drei Uebertragungsleitungen (3a, 3b, 3c) aufweisen, von denen mindestens eine polarisations-erhaltend ist, sowie einen Strahlteiler (4a) und zwei Polarisatoren (11a, 11b) zum Analysieren des reflektierten resp. transmittierten Lichts, und zwei akustooptische Modulatoren (14a, 14b) zum Modulieren der Eigenpolarisationen des einzukoppelnden Lichts.

9. Faseroptischer Stromsensor nach Anspruch 6, dadurch gekennzeichnet, dass der faseroptische Fabry-Perot-Resonator (1) in Transmission betrieben und der magnetooptische Faradayeffekt mit einem Sagnac-Interferometer gemessen wird, wobei die Mittel zum Einkoppeln von kohärentem Licht und Detektieren des magnetooptischen Faradayeffekts zwei polarisations-erhaltende Uebertragungsleitungen (3a, 3b) aufweisen, sowie einen polarisierenden Strahlteiler (4a) und zwei Polarisatoren (11a, 11b) zum Analysieren des transmittierten Lichts.

10. Faseroptischer Stromsensor nach Anspruch 6, dadurch gekennzeichnet, dass der faseroptische Fabry-Perot-Resonator (1) in Reflexion betrieben und der magnetooptische Faradayeffekt in direkt-Detektion gemessen wird, wobei die Mittel zum Einkoppeln von kohärentem Licht und Detektieren des magnetooptischen Faradayeffekts

    a) genau eine polarisations-erhaltende Uebertragungsleitung (3a),
    b) einen Viertelwellenverzögerer (6b) zwischen Uebertragungsleitung (3a) und faseroptischem Fabry-Perot-Resonator (1),
    c) einen polarisierenden Strahlteiler (4a) zum Ein- und Auskoppeln von Licht aus der Uebertragungsleitung (3a) und
    d) einen Kreuzpolarisator (7) und zwei Photodetektoren (8a, 8b) zum Analysieren des ausgekoppelten Lichts aufweisen.

## Claims

1. Fibre-optic current sensor having a single mode optical waveguide which is wound around an electrical conductor (2), having means for coupling coherent light into the single mode optical waveguide, and having means for detecting the intensity coupled out from the single mode optical waveguide, using the magneto-optic Faraday effect, characterised in that

    (a) the single mode optical waveguide is constructed, by means of a respective mirror (9a, 9b) provided at its two ends, as a fibre-optic Fabry-Perot resonator (1);
    (b) the Fabry-Perot resonator (1) has a length which corresponds to one half or to an integer multiple of one half of the wavelength of the coupled-in light;
    (c) the Fabry-Perot resonator (1) has the shape of a helix which passes around the electrical conductor (2) precisely N times, where N is a positive integer; and
    (d) the means for coupling in coherent light comprise a laser (5) stabilised to a resonant frequency of the fibre-optic Fabry-Perot resonator (1).

2. Fibre-optic current sensor according to Claim 1, characterised in that the helix has an angle of inclination ($\theta$) of approximately 30°.

3. Fibre-optic current sensor according to Claim 2, characterised in that the helix passes precisely once around the electrical conductor (2).

4. Fibre-optic current sensor according to Claim 3, characterised in that the fibre-optic Fabry-Perot resonator (1) is a quartz glass fibre and has a fineness (F) smaller than 100, where the ratio of the spacing of adjacent transmission maxima of the Fabry-Perot resonator to their half-power width is defined as the fineness.

5. Fibre-optic current sensor according to Claim 4, characterised in that the quartz glass fibre is a weakly birefringent glass fibre and in that the helix has a radius (R) which is greater than 10 mm.

6. Fibre-optic current sensor according to Claim 1, characterised in that the means for coupling in coherent light and for detecting the magneto-optic Faraday effect comprise at least one polarisation-conserving transmission line (3a) comprising a strongly birefringent glass fibre, which is connected to one end of the fibre-optic Fabry-Perot resonator (1).

7. Fibre-optic current sensor according to Claim 6, characterised in that the fibre-optic Fabry-Perot resonator (1) is operated in transmission and the magneto-optic Faraday effect is measured by direct detection, the means for coupling in coherent light and detecting the magneto-optic Faraday effect having three transmission lines (3a, 3b, 3c), of which at least one is polarisation-conserving, as well as a beam splitter (4a) and two polarisers (11a, 11b) to analyse the transmitted light.

8. Fibre-optic current sensor according to Claim 6, characterised in that the fibre-optic Fabry-Perot resonator (1) is operated in transmission and the magneto-optic Faraday effect is measured using heterodyne detection, the means for coupling in coherent light and detecting the magneto-optic Faraday effect having three transmission lines (3a, 3b, 3c), of which at least one is polarisation-conserving, as well as a beam splitter (4a) and two polarisers (11a, 11b) to analyse the reflected and transmitted light respectively, and two acousto-optic modulators (14a, 14b) to modulate the characteristic polarisations of the light to be coupled in.

9. Fibre-optic current sensor according to Claim 6, characterised in that the fibre-optic Fabry-Perot resonator (1) is operated in transmission and the magneto-optic Faraday effect is measured by a Sagnac interferometer, the means for coupling in coherent light and detecting the magneto-optic Faraday effect having two polarisation-conserving transmission lines (3a, 3b), as well as a polarising beam splitter (4a) and two polarisers (11a, 11b) to analyse the transmitted light.

10. Fibre-optic current sensor according to Claim 6, characterised in that the fibre-optic Fabry-Perot resonator (1) is operated in reflection and the magneto-optic Faraday effect is measured in direct detection, the means for coupling in coherent light and detecting the magneto-optic Faraday effect having
a) precisely one polarisation-conserving transmission line (3a),
b) a quarter-wave delay device (6b) between transmission line (3a) and fibre-optic Fabry-Perot resonator (1),
c) a polarising beam splitter (4a) for the coupling in and coupling out of light from the transmission line (3a) and,
d) a cross-polariser (7) and two photodetectors (8a, 8b) to analyse the light coupled out.

**Revendications**

1. Capteur de courant à fibre optique comportant un guide d'ondes lumineuses monomode, qui est enroulé autour d'un conducteur électrique (2), des moyens pour injecter de la lumière cohérente dans le guide d'ondes lumineuses monomode, et des moyens pour détecter l'intensité captée à la sortie du guide d'ondes lumineuses monomode en utilisant de l'effet Faraday magnéto-optique, caractérisé en ce que :
a) le guide d'ondes lumineuses monomode se présente, du fait respectivement d'un miroir (9a, 9b) présent à ses deux extrémités, comme un résonateur Fabry-Perot à fibre optique (1);
b) le résonateur Fabry-Perot (1) a une longueur qui correspond à un demi-multiple ou à un multiple entier d'une demi-longueur d'interférence de la lumière injectée;
c) le résonateur Fabry-Perot (1) a la forme d'une hélice qui s'enroule autour du conducteur électrique (2) exactement N fois, N étant un nombre entier positif, et
d) les moyens d'injection de la lumière cohérente comprennent un laser (5) stabilisé sur la fréquence de résonance du résonateur Fabry-Perot à fibre optique (1).

2. Capteur de courant à fibre optique selon la revendication 1, caractérisé en ce que l'hélice a un angle d'inclinaison (Θ) d'environ 30°.

3. Capteur de courant à fibre optique selon la revendication 2, caractérisé en ce que l'hélice entoure exactement une fois le conducteur électrique (2).

4. Capteur de courant à fibre optique selon la revendication 3, caractérisé en ce que le résonateur Fabry-Perot (1) à fibre optique est une fibre de verre quartzeux et a une finesse (F) inférieure à 100, la finesse étant définie comme le rapport de l'écart entre des maxima de transmission voisins du résonateur Fabry-Perot à sa largeur de bande effective.

5. Capteur de courant à fibre optique selon la revendication 4, caractérisé en ce que la fibre de verre quartzeux est une fibre de verre à faible biréfringence et l'hélice a un rayon (R) qui est plus grand que 10 mm.

6. Capteur de courant à fibre optique selon la revendication 1, caractérisé en ce que les moyens pour injecter la lumière cohérente et détecter l'effet Faraday magnéto-optique comprennent au moins une ligne de transmission maintenant une polarisation (3a) constituée d'une fibre de verre à forte biréfringence, qui est raccordée à une extrémité du résonateur Fabry-Perot à fibre optique (1).

7. Capteur de courant à fibre optique selon la revendication 6, caractérisé en ce que le résonateur Fabry-Perot à fibre optique (1) est exploité en transmission et l'effet Faraday magnéto-optique est mesuré par détection directe, les moyens d'injection de lumière cohérente et de détection de l'effet Faraday magnéto-optique comportant trois lignes de transmission (3a, 3b, 3c) dont au moins une maintient une polarisation, ainsi qu'une lame séparatrice (4a) et deux polarisateurs (11a, 11b) pour analyser la lumière transmise.

8. Capteur de courant à fibre optique selon la revendication 6, caractérisé en ce que le résonateur Fabry-Perot à fibre optique (1) est exploité en transmission et l'effet Faraday magnéto-optique est mesuré par détection hétérodyne, les moyens d'injection de lumière cohérente et de détection de l'effet Faraday magnéto-optique comportant trois lignes de transmission (3a, 3b, 3c) dont au moins une maintient une polarisation, ainsi qu'une lame séparatrice (4a) et deux polarisateurs (11a, 11b) pour analyser la lumière réfléchie et la lumière transmise, et deux modulateurs acousto-optiques (14a, 14b) pour moduler les polarisations propres de la lumière fournie.

9. Capteur de courant à fibre optique selon la revendication 6, caractérisé en ce que le résonateur Fabry-Perot à fibre optique (1) est exploité en transmisssion et l'effet Faraday magnéto-optique est mesuré à l'aide d'un interféromètre Sagnac, les moyens d'injection de lumière cohérente et de détection de l'effet Faraday magnéto-optique comportant deux lignes de transmission (3a, 3b) maintenant une polarisation, ainsi qu'une lame séparatrice polarisante (4a) et deux polarisateurs (11a, 11b) pour analyser la lumière transmise.

10. Capteur de courant à fibre optique selon la revendication 6, caractérisé en ce que le résonateur Fabry-Perot à fibre optique (1) est exploité en réflexion et l'effet Faraday magnéto-optique est mesuré par détection directe, les moyens d'injection de lumière cohérente et de détection de l'effet Faraday magnéto-optique comportant :

    a) exactement une ligne de transmission (3a) maintenant une polarisation,

    b) un retardateur quart d'onde (6b) entre la ligne de transmission (3a) et le résonateur Fabry-Perot à fibre optique (1),

    c) une lame séparatrice polarisante (4a) pour injecter la lumière dans la ligne de transmission (3a) et pour la capter en retour, et

    d) un polarisateur à prismes croisés (7) et deux photodétecteurs (8a, 8b) pour analyser la lumière sortante.

FIG.1

FIG.2

EP 0 356 670 B1

FIG.3

FIG.4

FIG.5

a)

b)

FIG. 6